Europäisches Patentamt

European Patent Office

Office européen des brevets

(19)

(11) Veröffentlichungsnummer : **0 131 680**
**B1**

(12) **EUROPÄISCHE PATENTSCHRIFT**

(45) Veröffentlichungstag der Patentschrift : **27.05.87**

(51) Int. Cl.⁴ : **C 30 B 11/00**

(21) Anmeldenummer : **84102762.6**

(22) Anmeldetag : **14.03.84**

(54) **Verfahren und Vorrichtung zur Vergrösserung axialer thermischer Gradienten für eine gerichtete Erstarrung von geschmolzenem Material.**

(30) Priorität : **21.06.83 DE 3322175**

(43) Veröffentlichungstag der Anmeldung :
**23.01.85 Patentblatt 85/04**

(45) Bekanntmachung des Hinweises auf die Patenterteilung : **27.05.87 Patentblatt 87/22**

(84) Benannte Vertragsstaaten :
**FR NL**

(56) Entgegenhaltungen :
**FR-A- 2 088 328**
**GB-A- 2 090 545**
**US-A- 3 532 155**

(73) Patentinhaber : **DORNIER SYSTEM GmbH**
**Postfach 1360**
**D-7990 Friedrichshafen (DE)**

(72) Erfinder : **Behrmann, Peter, Dr.-Ing.**
**Zu den Eichen 25**
**D-7777 Salem 2 (DE)**
Erfinder : **Koch, Hubert, Dipl.-Ing.**
**Sperlingweg 12**
**D-7990 Friedrichshafen 1 (DE)**

(74) Vertreter : **Landsmann, Ralf, Dipl.-Ing.**
**Kleeweg 3**
**D-7990 Friedrichshafen 1 (DE)**

**Beschreibung**

Die Erfindung betrifft ein Verfahren und eine Vorrichtung zur Vergrösserung axialer thermischer Gradienten für eine gerichtete Erstarrung von geschmolzenem Material, welches in einem mit einer Kartusche umgebenen metallurgischen Tiegel enthalten ist, der innerhalb einer mit einer Heiz- und Kühlzone versehenen ofenähnlichen Schmelz- und/oder Erstarrungseinrichtung angeordnet ist und wobei die Schmelze während des Erstarrungsvorganges relativ zur Schmelz- und/oder Erstarrungseinrichtung bewegt wird.

Derartige Einrichtungen sind aus der Literatur als Bridgeman-Öfen bekannt, in welchen die Erstarrung im wesentlichen durch Bewegen der Ofeneinrichtung relativ zu einem zu erstarrenden Material, im folgenden Schmelze genannt, bewirkt wird. Dabei ist es unwesentlich, ob der Ofen oder die Schmelze oder beide physikalisch bewegt werden.

Eine aus der DE-OS-30 31 747 bekannte Vorrichtung dient zur Gruppenzüchtung von Monokristallen durch eine gerichtete Kristallisation der Schmelze. Die Vorrichtung enthält einen zylindrischen Block aus einem elektrisch leitenden Material ; durchgehende, am Umfang des Blocks verteilte Bohrungen ; Behälter in Bohrungen, die zur Aufnahme des Impfkristalls und der zu kristallierenden Legierung bestimmt sind ; einen zum Block koaxial angeordneten Erhitzer und einen mit dem Block gleichachsig angeordneten Kühler. Der Kühler ist dabei in Form eines zylindrischen Behälters ausgeführt, dessen dem zylindrischen Block zugewandter Boden die Form einer konkaven Kegelfläche aufweist. Über dem Umfang ist er mit durchgehenden Bohrungen versehen. Diese Bohrungen sind gegenüber den Bohrungen des Blocks angeordnet und entsprechen diesen im Durchmesser.

Nachteilig bei derartigen Einrichtungen ist, dass bei mechanischen Berührungen der Schmelze oder der sie einhüllenden Kartusche mit der gegen sie bewegten Erstarrungseinrichtung Vibrationen erzeugt werden, welche eine geordnete Erstarrung nachhaltig stören. Werden derartige Berührungen vermieden, so wird durch den entstehenden Spalt die Wärmeübertragung behindert und dadurch der Wärmefluss innerhalb der Schmelze und damit der erreichbare thermische Gradient begrenzt. Zur Erreichung besonders homogener Kristalle während des Erstarrungsvorganges sind aber hohe thermische Gradienten anzustreben.

Aufgabe der Erfindung ist es, ein Verfahren und eine Vorrichtung zu schaffen, mit welcher in einer gegebenen Schmelz- und Erstarrungseinrichtung eine Vergrösserung des in dieser Einrichtung erreichbaren thermischen Gradienten ermöglicht wird, ohne dass zusätzliche thermische Kopplungen zwischen Schmelze und Erstarrungseinrichtung benötigt werden.

Zur Lösung der gestellten Aufgabe sind erfindungsgemäss die Merkmale von Anspruch 1 und 2 vorgesehen. Weitere vorteilhafte Ausbildungen ergeben sich aus den Unteransprüchen.

Der Vorteil der Erfindung besteht darin, dass gegenüber dem bisher Bekannten eine Verbesserung der Schmelzeigenschaften sowohl von Proben schon vorhandener als auch von neu zu erstellenden Gradientenöfen erzielt wird, ohne dass konstruktive Veränderungen am Ofen selbst vorgenommen werden müssen. Damit wird eine verbesserte und beschleunigte Herstellung von gerichtet erstarrten Bauteilen, z. B. von Turbinenschaufeln oder Halbleiterkristallen erreicht.

Die Vergrösserung des thermischen Gradienten wird dadurch erzielt, dass zum radialen Wärmetransport von der Heizzone auf die Schmelze sowie von der erstarrten Schmelze auf die Kühlzone eine grosse, durch die Dimension des Ofens selbst vorgegebene Oberfläche bereitgestellt wird. Der den thermischen Gradienten bestimmende Wärmefluss wird dagegen in einer Schmelze zusammengedrängt, deren Durchmesser bei radialsymmetrischer Geometrie wenigstens um den Faktor 1,5 kleiner ist als der die wärmetauschende Oberfläche bestimmende Durchmesser.

Dies wird mittels einer dickwandigen Kartusche erreicht, welche über ihren gesamten Umfang mit Schlitzen versehen ist, deren Tiefe möglichst gross ist. Das heisst, dass die Restdicke des Kartuschenmaterials im Bereich eines Schlitzes aus der geforderten mechanischen Festigkeit der Kartusche abzuleiten ist. Die so vorgesehenen Schlitze behindern wirkungsvoll den axialen Wärmetransport innerhalb der Kartusche. Ist der Abstand der Schlitze deutlich kleiner als der Abstand zwischen Heiz- und Kühlzone des Ofens, so erfolgt der Wärmetransport von der Heizzone auf die Kühlzone, von Isolationsverlusten abgesehen, im wesentlichen nur über die innerhalb der Kartusche befindliche Schmelze/erstarrte Schmelze. Ist die Schlitzbreite deutlich kleiner als der Schlitzabstand, so wird der radiale Wärmestrom, bedingt durch die Stege, gegenüber einer Vollkartusche (ohne Schlitze und Stege) oder einer Schmelze entsprechenden Durchmessers nur unwesentlich behindert.

Bei nichtradialsymmetrischer Anordnung der Schmelze ist das Verhältnis aus dem Querschnitt der Schmelze und dem Querschnitt der Kartusche entsprechend so zu wählen, dass der Umfang der Kartusche wenigstens um den Faktor 1,5 grösser ist als der Umfang der Schmelze.

Der radiale Wärmewiderstand bestimmt im wesentlichen den erreichbaren Gesamtwärmestrom, während der axiale thermische Gradient dem Quotienten des Wärmestromes über die Schmelze geteilt durch den Schmelzquerschnitt proportional ist. Mit dem Verfahren und der Vorrichtung wird bewirkt, dass über eine grosse äussere Oberfläche ein grosser Wärmestrom vom Ofen auf die Kartusche und umgekehrt erfolgt. Dieser Wärmestrom wird dabei über die breiten Stege relativ ungehindert der Schmelze zugeführt, während die Schlitze nahezu den gesamten Wärmestrom auf die im Durchmesser dünne Schmelze bündeln, so dass das Verhältnis aus Wärmestrom zu Schmelzquerschnitt maximiert wird.

Ein Ausführungsbeispiel ist folgend beschrieben und durch eine Skizze erläutert.

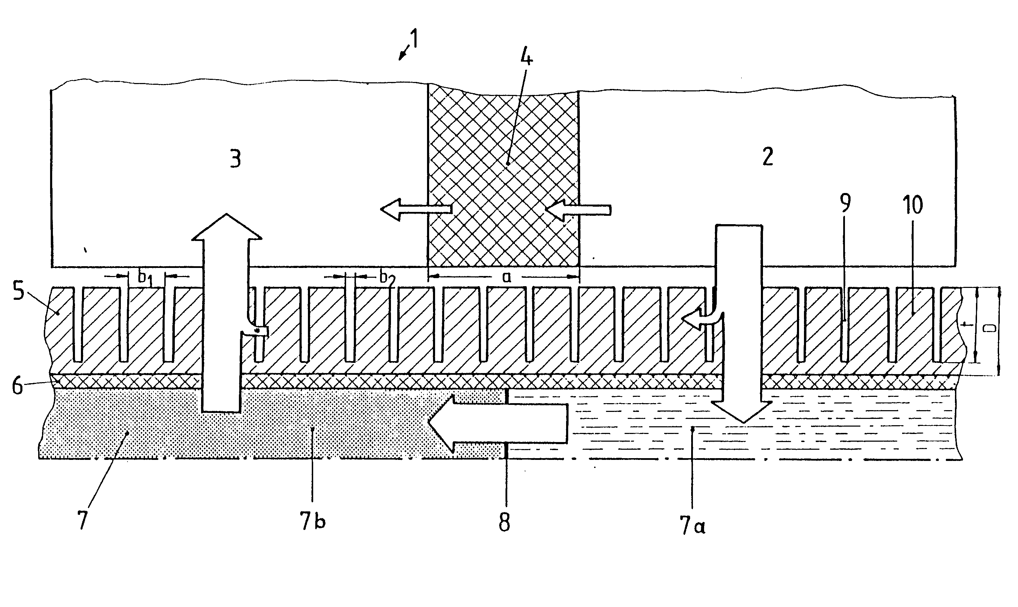

Die Figur zeigt einen Bridgeman-Ofen 1 mit einer Heizzone 2 und einer Kühlzone 3, welche durch eine Isolationsschicht 4 voneinander getrennt sind. In der zentralen Öffnung des Ofens 1 ist ein koaxiales System angeordnet, welches aus einer Kartusche 5, einem metallurgischen Tiegel 6 und einem darin befindlichen zu schmelzenden Material bzw. einer Schmelze 7 besteht. Das Temperaturprofil des Ofens 1 ist so gewählt, dass die gerichtet zu erstarrende Schmelze 7 zum Teil schmelzflüssig 7a, zum Teil erstarrt 7b vorliegt, wobei die Phasengrenze 8 zweckmässig im Bereich der Isolationsschicht 4 angeordnet ist. Die den Tiegel 6 umgebende Kartusche 5 ist mit Schlitzen 9 und Stegen 10 versehen, wobei die Breite $b_1$ der Stege 10 ein Vielfaches der Breite $b_2$ der Schlitze 9 beträgt. Die Breite $b_1$ der Stege 10 ist gegenüber der Breite a der Isolationszone 4 nur ein Bruchteil. Die Tiefe t der Schlitze 9 muss mindestens drei Vierteil der Dicke D der Kartuschen 5 betragen. Die Schlitze 9 bzw. Stege 10 sind vorzugsweise senkrecht zur Erstarrungsebene (siehe Richtungspfeile) des Schmelzmaterials 7 angeordnet, wobei diese für Sonderfälle auch schräg zur Erstarrungsebene verlaufen können. Die Schlitze 9 und Stege 10 können sowohl als in sich geschlossene Scheiben als auch in einer Schraubenlinie verlaufend angeordnet sein.

Die Wärmeflüsse sind hierbei quantitativ in Form von Pfeilen dargestellt, wobei die Breite dieser Pfeile die Grösse des entsprechenden Wärmeflusses andeutet. Der durch dicke Pfeile gekennzeichnete Wärmefluss strömt aus der Heizzone 2 über die Stege 10 der Kartusche 5 durch den Tiegel 6 senkrecht in das schmelzflüssige Material 7a und nach der Phasengrenze 8 axial in den Bereich der erstarrten Schmelze 7b. Von hier ab verläuft der Wärmefluss in umgekehrter Richtung in die Kühlzone 3. Ein bei der Wärmeflußzu- und -abfuhr durch einen dünnen Pfeil gekennzeichneter Wärmefluss strömt als Verluststrom über die Stege 10 und Schlitze 9 zur Kühlzone 3.

Die für das Bridgeman-Verfahren nötige Einrichtung zur mechanischen Bewegung von Ofen 1 relativ zur Kartusche 5 ist in der Figur nicht näher dargestellt.

**Patentansprüche**

1. Verfahren zur Vergrösserung axialer thermischer Gradienten für eine gerichtete Erstarrung von geschmolzenem Material, welches in einem mit einer Kartusche umgebenen metallurgischen Tiegel enthalten ist, der innerhalb einer mit einer Heiz- und Kühlzone versehenen ofenähnlichen Schmelz- und/oder Erstarrungseinrichtung angeordnet ist und wobei die Schmelze während des Erstarrungsvorganges relativ zur Schmelz- und/oder Erstarrungseinrichtung bewegt wird, dadurch gekennzeichnet, daß der während des Erstarrungsvorganges auftretende Wärmefluß senkrecht zur Erstarrungsebene in einer radialsymmetrisch angeordneten Schmelze (7) zusammengedrängt wird, bei der ihr Durchmesser gegenüber dem äusseren Durchmesser der Kartusche (5) um einen Faktor $\geq 1,5$ kleiner ist und der Wärmefluß senkrecht zur Erstarrungsebene weitgehend unbeeinflußt bleibt oder daß der während des Erstarrungsvorganges auftretende Wärmefluß senkrecht zur Erstarrungsebene in einer nichtradialsymmetrisch angeordneten Schmelze (7) zusammengedrängt wird, bei der der Umfang der Kartusche (5) um einen Faktor $\geq 1,5$ größer als der Umfang der Schmelze (7) ist und der Wärmefluß senkrecht zur Erstarrungsebene weitgehend unbeeinflußt bleibt.

2. Vorrichtung zur Durchführung des Verfahrens nach Anspruch 1, bestehend aus einem mit einer Heiz- und Kühlzone versehenen Ofen, eine darin angeordnete Kartusche und einen von der Kartusche umgebenen metallurgischen Tiegel, dadurch gekennzeichnet, daß die Kartusche (5) mit senkrecht zur Erstarrungsebene angeordneten Schlitzen (9) und Stegen (10) versehen ist, wobei die Tiefe (t) der Schlitze (9) mindestens drei Viertel der Dicke (D) der Kartusche (5) beträgt, die Breite ($b_2$) der Schlitze (9) kleiner als die Breite ($b_1$) der Stege (10) und die Breite ($b_1$) der Stege (10) kleiner als der halbe Abstand (a) zwischen Heiz- und Kühlzone (2, 3) des Ofens (1) ist.

3. Vorrichtung nach Anspruch 2, dadurch gekennzeichnet, daß die Schlitze (9) und Stege (10) ringförmig angeordnet sind.

4. Vorrichtung nach den Ansprüchen 2 und 3, dadurch gekennzeichnet, daß die Schlitze (9) und Stege (10) in einer Schraubenlinie angeordnet sind.

**Claims**

1. Process for increasing the axial thermal gradient in the directional solidification of fused material, held in a metallurgic melting-pot surrounded by a cartridge, and which is placed within a oven-like melting and/or solidification device provided with a heating and cooling zone, and the melting being moved relative to the melting and/or solidification device during the process of solidification, characterized thereby that the heatflow appearing during the solidification process is compressed vertically to the solidification level within a fluid melting (7) arranged radialsymmetrically, where its diameter is smaller than a factor $\geq 1,5$ compared to the outside diameter of the cartridge (5) and the heatflow vertical to the solidification level remains largely unaffected, or that the heatflow occurring during the solidification process is compressed vertically to the solidification level within a non radial-symmetric melting (7), the radius of the cartridge (5) being bigger by a factor $\geq 1.5$ than the radius of the melting (7) and the heatflow vertical to the solidification level remaining largely unifluenced.

2. A device for the realization of the process according to claim 1, consisting of an oven provided with a heating and cooling zone, a therein arranged cartridge and a metallurgic melting-pot surrounded by the cartridge, characterized thereby that the cartridge (5) is provided with slits (9) and crosspieces (10) arranged vertically to the solidification level, the depth of the slits (9) being at least three quarters of the diameter (D) of the cartridge (5), the width ($b_2$) of the slits (9) being smaller than the width ($b_1$) of the crosspieces (10), and the width ($b_1$) of the crosspieces (10) being smaller than half the distance (a) between heating and cooling zone (2, 3) of the oven (1).

3. Device according to claim 2, characterized thereby that the slits (9) and crosspieces (10) are arranged in a ring-shaped manner.

4. Device according to claims 2 and 3, characterized thereby that the slits (9) and crosspieces (10) are arranged in a screw line (helix).

**Revendications**

1. Procédé pour l'augmentation des gradients thermiques axiaux pour une solidification dirigée de matières fondues contenues dans un creuset métallurgique qui est entouré d'une cartouche et disposé à l'intérieur d'un système de fusion et/ou de solidification du genre four avec une zone de chauffage et une zone de refroidissement, la masse fondue étant déplacée, pendant le processus de solidification, par rapport au système de fusion et/ou de solidification, caractérisé par le fait que le flux de chaleur apparaissant pendant le processus de solidification est resserré perpendiculairement au plan de solidification à l'intérieur d'une masse fondue (7) présentant une disposition à symétrie radiale et dont le diamètre est inférieur d'un facteur $\geq 1.5$ au diamètre extérieur de la cartouche (5) et que le flux de chaleur perpendiculaire au plan de solidification n'est pas influencé dans une large mesure ; ou que le flux de chaleur produit pendant le processus de solidification est resserré dans la masse fondue (7) présentant une disposition à symétrie non radiale pour laquelle la circonférence de la cartouche (5) est supérieure d'un facteur $\geq 1.5$ à la circonférence de la masse fondue (7) et que le flux de chaleur perpendiculaire au plan de solidification n'est pas influencé dans une large mesure.

2. Dispositif pour la mise en œuvre du procédé selon la revendication 1, comprenant un four muni d'une zone de chauffage et d'une zone de refroidissement, d'une cartouche disposée à l'intérieur du four et d'un creuset métallurgique entouré par ladite cartouche, caractérisé par le fait que la cartouche (5) est munie de fentes (9) et de barrettes (10) orientées perpendiculairement au plan de solidification, la profondeur (t) des fentes (9) étant égale à au moins les trois quarts de l'épaisseur (D) de la cartouche (5), que la largeur (b2) des fentes (9) est inférieure à la largeur (b1) des barrettes (10) et que la largeur (b1) des barrettes (10) est inférieure à la moitié de la distance (a) entre les zones de chauffage et de refroidissement (2, 3) du four (1).

3. Dispositif selon la revendication 2, caractérisé par le fait que les fentes (9) et les barrettes (10) sont disposées en forme d'anneaux.

4. Dispositif selon l'une des revendications 2 et 3, caractérisé par le fait que les fentes (9) et les barrettes (10) sont disposées sur une ligne hélicoïdale.